# FASCICULE DE BREVET EUROPEEN

(11) **EP 3 591 476 B1**
(45) Date de publication et mention de la délivrance du brevet: **21.04.2021**
(21) Numéro de dépôt: 18181272.8
(22) Date de dépôt: 02.07.2018
(51) Int. Cl.: G04C 10/00, G04G 19/00

(54) **MONTRE THERMOELECTRIQUE TESTABLE PAR SON PORTEUR**
THERMOELEKTRISCHE ARMBANDUHR, DIE VON IHREM TRÄGER GETESTET WERDEN KANN
THERMOELECTRIC WATCH TESTABLE BY ITS WEARER

(43) Date de publication de la demande: 08.01.2020
(73) Titulaire: The Swatch Group Research and Development Ltd, 2074 Marin (CH)
(72) Inventeur: Gueissaz, François, 2036 Cormondrèche (CH); Jornod, Alain, 2000 Neuchâtel (CH); Theoduloz, Yves, 1400 Yverdon (CH)
(74) Mandataire: ICB SA

(56) Documents cités:
- EP-A1- 3 339 981
- EP-A2- 0 933 863
- EP-A2- 0 935 178

## Description

### Domaine technique

L'invention se rapporte à une montre thermoélectrique comprenant un générateur thermoélectrique, un élévateur de tension connecté audit générateur thermoélectrique et un circuit de gestion d'énergie connecté audit élévateur de tension et configuré pour gérer la charge d'au moins un élément de stockage d'énergie.

### Arrière-plan technologique

Dans le domaine des montres thermoélectriques, il est connu de l'homme du métier d'utiliser un générateur thermoélectrique qui permet, à partir de la chaleur du corps, de fournir de l'énergie électrique à une montre lorsque cette dernière se trouve sur le poignet. Le générateur thermoélectrique produisant une faible tension, un élévateur de tension permet d'augmenter la tension produite de sorte à obtenir une tension suffisamment grande pour alimenter un circuit de gestion d'énergie. Le circuit de gestion d'énergie permet de charger au moins un élément de stockage tel qu'une batterie de sorte à alimenter un moteur de la montre thermoélectrique même lorsque les conditions de génération d'énergie thermoélectrique ne sont plus remplies. L'intensité de la génération thermoélectrique peut être affichée à l'aide d'un bar-graphe circulaire en périphérie du cadran de la montre thermoélectrique. Un utilisateur peut ainsi voir si la génération thermoélectrique est active.

Un inconvénient est que le bar-graphe utilise un afficheur LCD qui est piloté par une sortie du circuit de gestion d'énergie. L'afficheur LCD fonctionne en continu et consomme quelques microwatts, dans le meilleur des cas, et jusqu'à des centaines de microwatts. Considérant que la puissance thermoélectrique générée par un dispositif porté au poignet ne dépasse que difficilement quelques microwatts au repos, il apparaît qu'un tel afficheur LCD pénalise grandement le budget énergétique. EP 3 339 981 A1, EP 0 935 178 A2 et EP 0 933 863 A2 divulguent une montre thermoélectrique selon le préambule de la revendication 1.

### Résumé de l'invention

Le but de la présente invention est de pallier l'inconvénient cité précédemment.

A cet effet, l'invention se rapporte à une montre thermoélectrique selon la revendication 1.

Ainsi, comme nous allons le voir en détail par la suite, lorsque la sortie de gestion d'énergie passe d'un état à un autre état (via une transition montante ou descendante), la diode électroluminescente émet une impulsion lumineuse (un flash lumineux). Cela permet à l'utilisateur de savoir quand la génération thermoélectrique est activée ou désactivée.

Conformément à des modes de réalisation non limitatifs de l'invention, la montre thermoélectrique peut présenter les caractéristiques des revendications 2 et suivantes, prises seules ou selon toutes les combinaisons techniquement possibles.

### Brève description des figures

L'invention sera décrite ci-après de manière plus détaillée à l'aide des dessins annexés, donnés à titre d'exemples nullement limitatifs, dans lesquels :
- La figure 1 représente schématiquement une montre thermoélectrique selon l'invention, ladite montre thermoélectrique comprenant un générateur de tension, un élévateur de tension, et un circuit de gestion d'énergie,
- La figure 2a représente le circuit de gestion d'énergie de la figure 1 connecté avec un condensateur, lui-même couplé à une diode électroluminescente, selon une première variante de réalisation non limitative d'un premier mode de réalisation de l'invention,
- La figure 2b représente le circuit de gestion d'énergie de la figure 1 connecté avec un condensateur, lui-même couplé à une diode électroluminescente, selon une deuxième variante de réalisation non limitative du premier mode de réalisation de l'invention,
- La figure 3 représente le circuit de gestion d'énergie de la figure 1 connecté avec deux condensateurs, chacun couplé à une diode électroluminescente, selon un deuxième mode de réalisation non limitatif.

### Description détaillée de l'invention

Les éléments identiques, par structure ou par fonction, apparaissant sur différentes figures conservent, sauf précision contraire, les mêmes références.

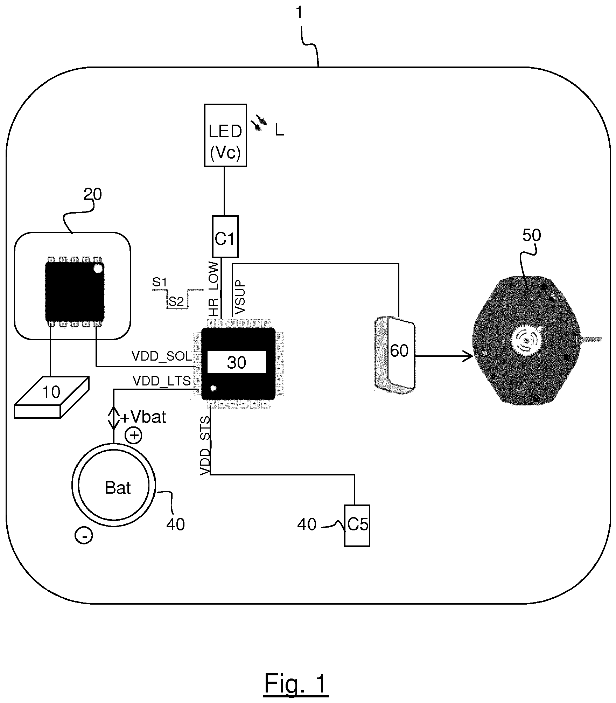

La montre thermoélectrique 1 selon l'invention est décrite en référence aux figures 1 à 3.

Telle qu'illustrée sur la figure 1, la montre thermoélectrique 1 comprend :
- un générateur thermoélectrique 10 ;
- un élévateur de tension 20 ;
- un circuit de gestion d'énergie 30 ;
- au moins un condensateur C1 couplé à une diode électroluminescente LED ;
- ladite diode électroluminescente LED.

La montre thermoélectrique 1 comprend un outre :
- un élément de stockage d'énergie 40 ;
- un moteur 50 configuré pour mettre en mouvement les aiguilles et cadran(s) (non illustrés) de la montre thermoélectrique 1 ;
- un résonateur 60 configuré pour servir de base de fréquence pour la montre thermoélectrique 1.

Dans la suite de la description, la montre thermoélectrique 1 est également appelée montre 1. Les éléments de la montre 1 sont décrits en détail ci-après.

### • Générateur thermoélectrique 10

Le générateur thermoélectrique 10 est configuré pour produire une énergie électrique, à savoir une tension faible, de l'ordre de quelques millivolts (mV) à partir de la chaleur du corps humain lorsque la montre 1 se trouve sur le poignet d'un utilisateur. Dans un exemple non limitatif, la tension est comprise entre 6 et 12mV. On notera que la génération de l'énergie électrique prend normalement moins d'une seconde lorsque la montre 1 est mise sur le poignet.

Ainsi, le générateur thermoélectrique 10 devient actif lorsque la montre est portée sur le poignet. Le générateur thermoélectrique 10 permet de démarrer la montre 1 lorsque la batterie de cette dernière est déchargée.

Les générateurs thermoélectriques étant connus de l'homme du métier, le générateur thermoélectrique 10 n'est pas décrit en détail ici.

Le générateur thermoélectrique 10 est connecté à l'élévateur de tension 20.

### • Elévateur de tension 20

L'élévateur de tension 20 est configuré pour augmenter la tension générée par le générateur thermoélectrique 10 de sorte à obtenir une tension suffisamment grande pour alimenter le circuit de gestion d'énergie 30. Cette tension est de l'ordre du Volt. Dans un exemple non limitatif, elle est égale à 2,5V.

L'élévateur de tension 20 est connecté au circuit de gestion d'énergie 30.

La tension générée se retrouve sur une entrée VDD_SOL dudit circuit de gestion d'énergie 30. Ainsi, une tension supérieure ou égale à un seuil (2,5V dans l'exemple non limitatif décrit), signifie que le générateur thermoélectrique 10 est devenu actif, en d'autres termes qu'il a débuté une génération d'énergie électrique.

Les élévateurs de tension étant connus de l'homme du métier, l'élévateur de tension 20 n'est pas décrit en détail ici.

### • Circuit de gestion d'énergie 30 et élément de stockage d'énergie 40

Le circuit de gestion d'énergie 30 est configuré pour gérer la charge d'au moins un élément de stockage d'énergie 40.

Dans un mode de réalisation non limitatif, le circuit de gestion d'énergie 30 est un microcontrôleur programmable configuré pour réaliser la charge dudit au moins un élément de stockage d'énergie 40.

Dans un mode de réalisation non limitatif, le circuit de gestion 30 comporte un étage amplificateur push-pull de sorte à obtenir des transitions montantes et descendantes sur la sortie HR_LOW décrite ci-après, avec une certaine capacité à délivrer du courant, typiquement 1 à 2 mA dans un mode de réalisation non limitatif.

Tel qu'illustré sur la figure 1, le circuit de gestion d'énergie 30 comprend notamment :
- une entrée VDD_SOL,
- une sortie HR_LOW,
- une sortie VSUP,
- une sortie VDD_LTS,
- une sortie VDD_STS.

Grâce à la tension reçue sur son entrée VDD_SOL, le circuit de gestion d'énergie 30 peut alimenter ledit au moins un élément de stockage d'énergie 40.

Dans un exemple non limitatif, ledit au moins un élément de stockage d'énergie 40 est une batterie Bat. La batterie Bat permet d'alimenter par exemple le moteur 50 de la montre 1 même lorsqu'il n'y a plus de génération d'énergie thermoélectrique.

Dans un mode de réalisation non limitatif, le circuit de gestion d'énergie 30 est configuré pour gérer la charge de deux éléments de stockage d'énergie 40. Chaque élément de stockage d'énergie 40 est connecté au circuit de gestion d'énergie 30 via les sorties respectives VDD_LTS et VDD_STS.

Dans un mode de réalisation non limitatif, un premier élément de stockage d'énergie 40 est un élément de stockage d'énergie à court terme (« Short Term Storage » en anglais) et un deuxième élément de stockage d'énergie 40 est un élément de stockage d'énergie à long terme (« Long Term Storage » en anglais). Dans un exemple non limitatif, l'élément de stockage d'énergie à court terme est un condensateur référencé C5 sur la figure 1, et l'élément de stockage d'énergie à long terme est une batterie rechargeable référencée Bat sur la figure 1. Dans un exemple non limitatif, la batterie Bat est une batterie Lithium-Ion.

Le condensateur C5 et la batterie Bat sont pris comme exemples non limitatifs dans la suite de la description.

Dans un mode de réalisation non limitatif, ledit circuit de gestion d'énergie 30 est configuré pour gérer alternativement la charge du condensateur C5 et de la batterie Bat de sorte à alimenter par exemple le moteur 50 de ladite montre 1. A cet effet, il comprend en outre une pluralité de commutateurs (non illustrés).

Ainsi, le circuit de gestion d'énergie 30 commence par charger, via son entrée VDD_SOL, le condensateur C5 qui se charge en quelques secondes (entre 3 à 5 secondes typiquement selon l'expérience produit visée). Puis, lorsque ce dernier est chargé (il a atteint une tension suffisante, entre 1,5V et 3V par exemple), le circuit de gestion d'énergie 30 déconnecte le condensateur C5 de son entrée VDD_SOL et il charge via son entrée VDD_SOL la batterie Bat qui se charge plus lentement en quelques heures voire quelques jours, jusqu'à atteindre une tension suffisante, entre 1,5V et 3V par exemple.

Pendant que la batterie Bat se charge, le condensateur C5 se décharge au niveau de la sortie VSUP, ce qui permet d'alimenter le moteur 50 de la montre 1 et ainsi démarrer le mouvement de la montre 1. Le condensateur C5 se décharge en effet en quelques secondes.

La batterie Bat permet de prendre le relais du condensateur C5 pour alimenter le moteur 50. La batterie Bat se décharge également sur la sortie VSUP ce qui permet d'alimenter le moteur 50 de la montre 1 pendant quelques mois. La batterie Bat peut en effet mettre quelques mois à se décharger.

Lorsque le condensateur C5 et la batterie Bat ont atteint chacun une tension suffisante respective, le circuit de gestion d'énergie 30 connecte les deux en parallèle.

Ainsi, lorsque le générateur thermoélectrique 10 est actif, l'énergie électrique générée par le générateur thermoélectrique 10 arrive sur l'entrée VDD_SOL, ce qui permet de charger le condensateur C5 et la batterie Bat.

Lorsque le générateur thermoélectrique 10 est inactif, à savoir il ne génère plus d'énergie électrique, le condensateur C5 et la batterie Bat sont déconnectés de l'entrée VDD_SOL.

Le générateur thermoélectrique 10 devient inactif lorsque par exemple la montre 1 est à l'équilibre thermique et n'est plus portée sur le poignet. Lorsqu'elle est de nouveau mise sur le poignet, la gestion alternée de la charge du condensateur C1 et de la batterie Bat décrite précédemment reprend.

La sortie HR_LOW du circuit de gestion d'énergie 30 est configurée pour :
- passer d'un premier état logique S1 à un deuxième état logique S2 lorsque ledit générateur thermoélectrique 10 débute une génération d'énergie électrique, et
- passer du deuxième état logique S2 au premier état logique S1 lorsque ledit générateur thermoélectrique 10 achève une génération d'énergie électrique.

La sortie HR_LOW permet ainsi de signaler l'activité du générateur thermoélectrique 10.

Dans la suite, on conviendra que le premier état logique S1 est un état haut, et le deuxième état logique S2 est un état bas. Toutefois, cela pourrait être l'inverse.

Dans un mode de réalisation non limitatif, l'état haut S1 est au potentiel +Vbat et l'état bas S2 est au potentiel -Vbat.

Ainsi, la sortie HR_LOW est en transition montante lorsqu'elle passe de l'état bas S2 à l'état haut S1 et est en transition descendante lorsqu'elle passe de l'état haut S1 à l'état bas S2.

Plus particulièrement, la sortie HR_LOW est configurée pour :
- passer de l'état haut S1 à l'état bas S2 lorsque ledit générateur thermoélectrique 10 débute une génération d'énergie électrique, et
- passer de l'état bas S2 à l'état haut S1 lorsque ledit générateur thermoélectrique 10 achève une génération d'énergie électrique.

L'état bas de la sortie HR_LOW signifie que le générateur thermoélectrique 10 est actif. L'état haut de la sortie HR_LOW signifie que le générateur thermoélectrique 10 est inactif.

On estime que, au cours d'une utilisation normale, la sortie HR_LOW ne peut pas avoir plus d'une centaine de transitions montantes et/ou descendantes par jour. Une centaine de transitions par jour correspond à un courant moyen inférieur à 0,1 microampères au travers de l'élément de couplage C1 cité plus bas, ce qui représente un faible pourcentage de consommation de la montre 1, inférieur à 10 %.

Le circuit de gestion d'énergie 30 est connecté audit au moins un condensateur C1 décrit ci-après.

### • Condensateur C1 et diode électroluminescente LED

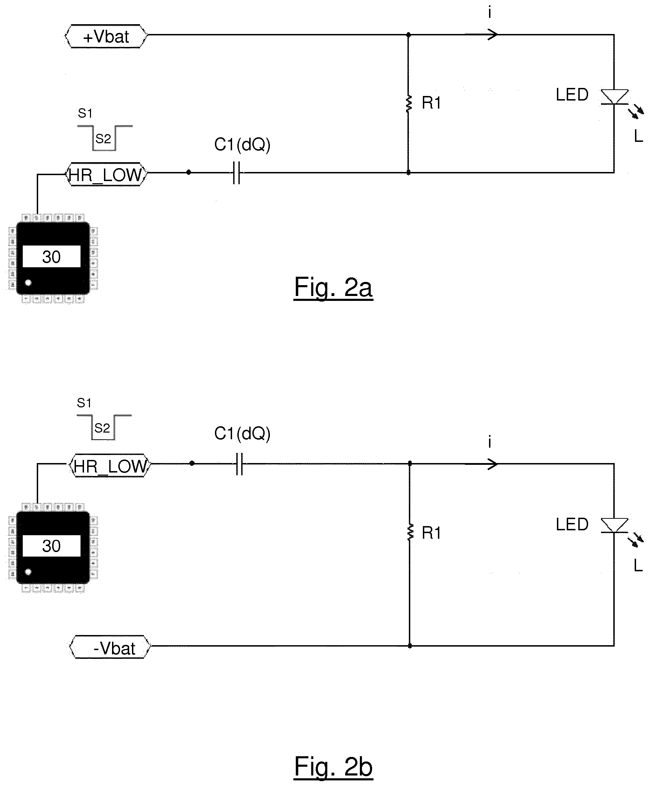

Tel qu'illustré sur la figure 1, 2a et 2b, ledit au moins un condensateur C1 est couplé à une diode électroluminescente LED, et est configuré pour :
- subir une variation de charge dQ lorsque ladite sortie HR_LOW dudit circuit de gestion d'énergie 30 passe d'un état S1, S2 à un autre état S2, S1,
- alimenter en courant ladite diode électroluminescente LED lorsqu'il subit ladite variation de charge dQ.

Le courant qui alimente la diode électroluminescente LED est égal à dQ/dt. La charge d'un condensateur étant exprimée par Q=C*U, on a Q1=C1*Vbat au maximum dans l'exemple non limitatif pris, et dQ = + ou - Q1.

Le condensateur C1 est connecté en série avec ladite diode électroluminescente LED.

Lorsque le condensateur C1 subit une variation de charge dQ, le courant de charge ou décharge i, autrement appelé courant i, nécessaire à sa charge ou décharge, circule de façon transitoire dans la diode électroluminescente LED lui permettant d'émettre une impulsion lumineuse L dans le spectre du visible, autrement appelée impulsion lumineuse visible L ou impulsion lumineuse L.

On notera qu'après une transition montante ou descendante de la sortie HR_LOW, lorsque ladite sortie HR_LOW reste dans un des deux états S1, S2, il n'y aucun courant i qui circule dans la diode électroluminescente LED. Ainsi, la diode électroluminescente LED ne consomme pas en régime stationnaire mais uniquement pendant les transitions montante et descendante. Son potentiel moyen est Uq=0.

Le courant i qui parcourt la diode électroluminescente LED est en fait une impulsion de courant puisqu'il est produit uniquement lorsque le condensateur C1 subit une variation de charge dQ, à savoir lors des transitions montante ou descendante de la sortie HR_LOW. L'intensité de cette impulsion de courant est de l'ordre du milliampère. Dans un exemple non limitatif, elle est comprise entre 1 et 10 mA. On notera que l'intensité des impulsions de courant tombe typiquement à 10% après une durée de moins de 50 millisecondes. Ainsi, l'impulsion lumineuse L émise par la diode électroluminescente LED est perçue pendant une durée typiquement inférieure à 50 millisecondes.

Dans un mode de réalisation non limitatif, ledit au moins un condensateur C1 est connecté à une résistance R1. La résistance R1 est connectée en parallèle avec ladite au moins une diode électroluminescente LED.

La résistance R1 permet une décharge lente et progressive dudit condensateur C1 après chaque transition montante ou descendante de la sortie HR_LOW, à savoir quand la diode électroluminescente LED correspondante ne conduit plus. On notera que, dans un exemple non limitatif, la résistance R1 conduit le condensateur C1 à se décharger de 90 à 99% en 5 et 10 secondes entre chaque transition. Les constantes de temps RC sont ainsi typiquement situées entre 5 et 10 secondes. Le condensateur C1 se décharge de sorte à obtenir une différence de potentiel nulle à ses bornes.

La diode électroluminescente LED est quant à elle configurée pour émettre une impulsion lumineuse visible L lorsqu'elle est parcourue par le courant de charge ou décharge i dudit condensateur C1. Dans la suite de la description, l'impulsion lumineuse visible L est également appelée impulsion lumineuse L.

Dans un mode de réalisation non limitatif, la diode électroluminescente LED est disposée derrière une ouverture d'un cadran de la montre 1 de sorte que l'impulsion lumineuse L soit visible par l'utilisateur de la montre 1.

Dans un premier mode de réalisation non limitatif illustré sur la figure 2a, ledit au moins un condensateur C1 est couplé à une diode électroluminescente LED verte, et est configuré pour se charger lorsque ladite sortie HR_LOW dudit circuit de gestion d'énergie 30 passe de l'état haut S1 à l'état bas S2, à savoir lorsque ladite sortie HR_LOW est en transition descendante.

Cela correspond à un début de génération d'énergie électrique par le générateur thermoélectrique 10. Le courant i nécessaire pour la charge du condensateur C1 passe par la diode électroluminescente LED verte qui émet alors une impulsion lumineuse L verte.

Le changement d'état de la sortie HR_LOW cause ainsi l'émission d'une impulsion lumineuse L par la diode électroluminescente LED.

Ainsi, lorsque le générateur thermoélectrique 10 débute une génération d'énergie (il devient actif), la diode électroluminescente LED verte émet une impulsion lumineuse L verte qui est visible par l'utilisateur de la montre 1. L'utilisateur sait alors que le générateur thermoélectrique 10 est en train de fonctionner, à savoir que le générateur thermoélectrique 10 débute la génération d'énergie électrique.

Dans un exemple non limitatif, le générateur thermoélectrique 10 devient actif lorsque la montre 1 est mise sur le poignet de l'utilisateur. La montre 1 reçoit en effet la chaleur du corps humain.

Après la transition descendante, lorsque la sortie HR_LOW reste à l'état bas S2 (le générateur thermoélectrique 10 est toujours actif), la valeur du courant i qui circule dans la diode électroluminescente LED verte tombe rapidement à zéro. Par conséquent l'utilisateur ne voit plus de flash lumineux vert.

Lorsque la sortie HR_LOW passe de l'état bas S2 à l'état haut S1 (le générateur thermoélectrique 10 devient inactif), il n'y aucun courant i qui circule dans la diode électroluminescente LED verte. Le condensateur C1 qui est connecté à une résistance R1 se décharge de sorte à obtenir une différence de potentiels nulle à ses bornes.

On notera que l'anode de la diode électroluminescente LED verte est connectée à la borne positive de la batterie +Vbat. Toutefois, dans un autre mode de réalisation non limitatif non illustré, l'anode de la diode électroluminescente LED verte pourrait être connectée à la borne négative -Vbat de la batterie Bat ou tout autre potentiel statique. Cela permet dans tous les cas d'avoir une différence de potentiel aux bornes de la diode électroluminescente LED verte lorsque l'on passe à l'état bas S2 qui est au potentiel -Vbat dans l'exemple non limitatif pris, de sorte qu'un courant puisse circuler dans la diode électroluminescente LED verte.

Dans un deuxième mode de réalisation non limitatif illustré sur la figure 2b, ledit au moins un condensateur C1 est couplé à une diode électroluminescente LED rouge, et est configuré pour se décharger lorsque ladite sortie HR_LOW dudit circuit de gestion d'énergie 30 passe de l'état bas S2 à l'état haut S1, à savoir lorsque ladite sortie HR_LOW est en transition montante.

Cela correspond à un arrêt de la génération d'énergie électrique par le générateur thermoélectrique 10. Le courant i nécessaire pour la décharge du condensateur C1 passe par la diode électroluminescente LED rouge qui émet alors une impulsion lumineuse L rouge.

Le changement d'état de la sortie HR_LOW cause l'émission d'une impulsion lumineuse L de la diode électroluminescente LED.

Ainsi, lorsque le générateur thermoélectrique 10 achève une génération d'énergie (il devient inactif), la diode électroluminescente LED rouge émet une impulsion lumineuse L rouge qui est visible par l'utilisateur de la montre 1. L'utilisateur sait alors que le générateur thermoélectrique 10 est en train d'arrêter de fonctionner, à savoir il achève la génération d'énergie électrique.

Dans un exemple non limitatif, le générateur thermoélectrique 10 devient inactif lorsque la montre 1 n'est plus portée sur le poignet de l'utilisateur. La montre 1 n'est en effet plus en contact avec la chaleur du corps humain et tend ainsi vers l'équilibre thermique aux bornes du générateur thermoélectrique.

Dans un autre exemple non limitatif, le générateur thermoélectrique 10 devient inactif lorsque la montre 1 se trouve en plein soleil avec un cadran foncé qui absorbe l'énergie du soleil. Même si elle reste sur le poignet, la carrure de la montre 1 devient plus chaude que le poignet. Le générateur thermoélectrique 10 peut s'arrêter plusieurs fois dans la journée. On estime que, au cours d'une utilisation normale, le générateur thermoélectrique 10 peut s'arrêter et redevenir actif au maximum une centaine de fois par jour.

Après la transition montante, lorsque la sortie HR_LOW reste à l'état haut S1 (le générateur thermoélectrique 10 est toujours inactif), la valeur du courant i qui circule dans la diode électroluminescente LED rouge tombe rapidement à zéro. Par conséquent l'utilisateur ne voit plus de flash lumineux rouge.

Lorsque la sortie HR_LOW passe de l'état haut S1 à l'état bas S2 (le générateur thermoélectrique 10 devient actif), aucun courant i ne circule dans la diode électroluminescente LED rouge. Le condensateur C1 qui est connecté à une résistance R1 se décharge de sorte à obtenir une différence de potentiel nulle à ses bornes.

On notera que la cathode de la diode électroluminescente LED rouge est connectée à la borne négative de la batterie -Vbat. Toutefois, dans un autre mode de réalisation non limitatif non illustré, la cathode de la diode électroluminescente LED rouge pourrait être connectée à la borne positive +Vbat de la batterie Bat ou tout autre potentiel statique. Cela permet dans tous les cas d'avoir une différence de potentiel aux bornes de la diode électroluminescente LED rouge lorsque l'on passe à l'état haut S1 qui est au potentiel +Vbat dans l'exemple non limitatif pris, de sorte qu'un courant puisse circuler dans la diode électroluminescente LED rouge.

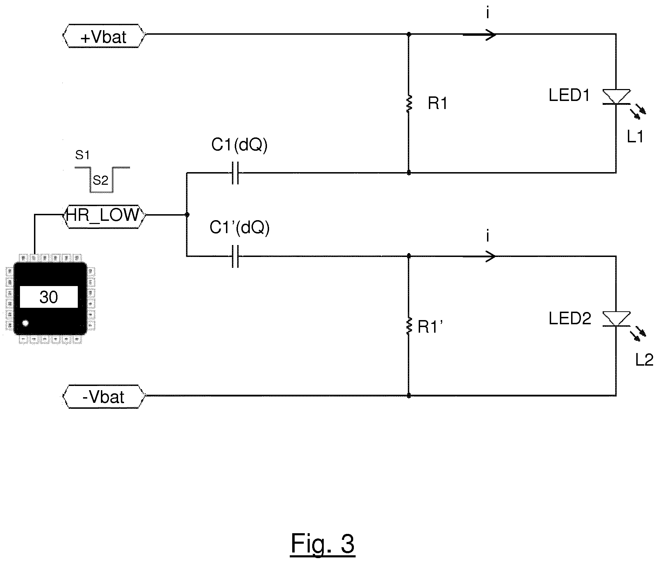

Dans un troisième mode de réalisation non limitatif illustré sur la figure 3, ledit circuit de gestion d'énergie 30 est connecté à deux condensateurs C1, C1' chacun couplé à une diode électroluminescente LED1, LED2.

Dans un mode de réalisation non limitatif, une diode électroluminescente LED1 est verte, et l'autre diode électroluminescente LED2 est rouge.

Dans un mode de réalisation non limitatif, l'un des condensateurs est configuré pour subir une variation de charge dQ lorsque ladite sortie HR_LOW passe de l'état haut S1 à l'état bas S2 et l'autre des condensateurs est configuré pour subir une variation de charge dQ lorsque ladite sortie HR_LOW passe de l'état bas S2 à l'état haut S1.

Dans une variante de réalisation non limitative, l'un des condensateurs est configuré pour se charger lorsque ladite sortie HR_LOW passe de l'état haut S1 à l'état bas S2 et l'autre des condensateurs est configuré pour se décharger lorsque ladite sortie HR_LOW passe de l'état bas S2 à l'état haut S1.

Ainsi, selon cette variante de réalisation non limitative, le condensateur C1 est configuré pour se charger lorsque ladite sortie HR_LOW passe de l'état haut S1 à l'état bas S2, et le condensateur C1' est configuré pour se décharger lorsque ladite sortie HR_LOW passe de l'état bas S2 à l'état haut S1.

Ainsi, le courant i nécessaire pour charger le condensateur C1 circule dans la diode électroluminescente LED1 verte, et le courant i nécessaire pour décharger le condensateur C1' circule dans la diode électroluminescente LED2 rouge.

La diode électroluminescente LED1 verte émet une impulsion lumineuse L1 verte lorsque le générateur thermoélectrique 10 débute une génération d'énergie électrique et la diode électroluminescente LED2 rouge émet une impulsion lumineuse L2 rouge lorsque le générateur thermoélectrique 10 achève une génération d'énergie électrique.

De cette manière, l'utilisateur de la montre 1 peut visualiser via des flashs lumineux L1 vert ou L2 rouge respectivement le début et l'arrêt de la génération d'énergie électrique par le générateur thermoélectrique 10.

On notera qu'une impulsion lumineuse L1 verte, visible par l'utilisateur, apparaît au bout de quelques secondes après que la montre 1 a été placée au poignet, une fois que l'élément de stockage d'énergie à court terme C5 s'est chargé avec l'énergie électrique produite par le générateur thermoélectrique 10.

On notera qu'une impulsion lumineuse L2 rouge, visible par l'utilisateur, apparaît au bout de quelques secondes à quelques minutes, selon les conditions thermiques, après que la montre 1 a été retirée du poignet. Cette durée correspond au temps que met le fond de la montre 1 qui a été réchauffé par la chaleur du corps humain à se refroidir.

On notera que l'intensité lumineuse de l'impulsion lumineuse L d'une diode électroluminescente dépend de la manière dont le condensateur C1 correspondant se charge ou se décharge. La perception physiologique de cette impulsion lumineuse L dépend essentiellement de son intégrale temporelle, proportionnelle à la vitesse de charge ou décharge du condensateur C1 correspondant. La tension aux bornes du condensateur C1 étant fixe (égale à +ou-Vbat), on ajuste la valeur du condensateur C1 pour obtenir une intensité d'impulsion lumineuse L déterminée.

On notera qu'une diode électroluminescente verte comporte une tension de conduction généralement supérieure à celle d'une diode électroluminescente rouge et un rendement inférieur à celui d'une diode électroluminescente rouge.

Aussi, selon le type de diode électroluminescente, on ajuste la valeur du condensateur C1 correspondant. Pour avoir la même perception physiologique de l'impulsion lumineuse L entre les deux diodes électroluminescentes verte et rouge, on augmente typiquement la valeur du condensateur C1 correspondant à la diode électroluminescente LED1 verte par rapport à celle du condensateur C1 correspondant à la diode électroluminescente LED2 rouge. Dans un exemple non limitatif, la valeur du condensateur C1 correspondant à la diode électroluminescente LED1 verte est égale à 22 µF et la valeur du condensateur C1 correspondant à la diode électroluminescente LED2 rouge est égale à 10 µF. Ainsi, pour une valeur de 22 µF, on obtient une charge totale de 55µC (Coulomb) pour une tension batterie Vbat égale à 2,5V. Pour une valeur de 10 µF, on obtient une charge totale de 25µC (Coulomb) pour une tension batterie Vbat égale à 2,5V. Ainsi, une transition descendante ou montante utilise une charge très faible qui correspond à un courant de charge/décharge i de quelques milliampères. Par conséquent, un courant de charge/décharge i faible est utilisé pour émettre une impulsion lumineuse verte ou rouge visible en plein jour. Très peu de courant est consommé pour avertir l'utilisateur de la génération ou non-génération thermoélectrique.

Dans un mode de réalisation non limitatif, une diode électroluminescente LED présente une tension de conduction Vc comprise entre 1,5V et 3V. Par conséquent, pour rendre les impulsions lumineuses L possibles, la tension batterie Vbat doit être supérieure à la tension de conduction Vc. Dans un mode de réalisation non limitatif, la tension batterie Vbat est ainsi supérieure à 1.5V. Dans une variante de réalisation non limitative, la tension batterie Vbat est comprise entre 2V et 4V. Cette plage de valeurs correspond aux batteries Lithium-Ion que l'on trouve couramment sur le marché. Cette plage de valeurs suffit à faire circuler un courant dans une diode électroluminescente LED de sorte que cette dernière émette une impulsion lumineuse L visible en plein jour. Ainsi, la diode électroluminescente LED permet de transformer une énergie électrique en une impulsion lumineuse largement visible en plein jour.

Bien entendu, la présente invention ne se limite pas à l'exemple illustré mais est susceptible de diverses variantes et modifications qui apparaîtront à l'homme du métier.

Ainsi, dans un autre mode de réalisation non limitatif, une diode électroluminescente LED émet une autre couleur que le rouge ou le vert.

## Revendications

1. Montre thermoélectrique (1) comprenant :
- un générateur thermoélectrique (10),
- un élévateur de tension (20) connecté audit générateur thermoélectrique (10),
- un circuit de gestion d'énergie (30) connecté audit élévateur de tension (20) et configuré pour gérer la charge d'au moins un élément de stockage d'énergie (40), ledit circuit de gestion d'énergie (30) comprenant une sortie (HR_LOW) configurée pour passer d'un premier état logique (S1) à un deuxième état logique (S2) lorsque ledit générateur thermoélectrique (10) débute une génération d'énergie électrique, et pour passer du deuxième état logique (S2) au premier état logique (S1) lorsque ledit générateur thermoélectrique (10) achève la génération d'énergie électrique,
**caractérisée en ce qu'**elle comprend en outre au moins un condensateur (C1) connecté audit circuit de gestion d'énergie (30), couplé à une diode électroluminescente (LED), et configuré pour :
- subir une variation de charge (dQ) lorsque ladite sortie (HR_LOW) dudit circuit de gestion d'énergie (30) passe soit du premier état (S1) au deuxième état (S2), soit du deuxième état (S2) au premier état (S1),
- alimenter en courant ladite diode électroluminescente (LED) lorsqu'il subit ladite variation de charge (dQ), ladite diode électroluminescente (LED) étant configurée pour émettre une impulsion lumineuse dans le spectre du visible (L) lorsqu'elle est parcourue par ledit courant.

2. Montre thermoélectrique (1) selon la revendication précédente, selon laquelle une résistance (R1) est branchée en parallèle de la diode électroluminescente (LED).

3. Montre thermoélectrique (1) selon l'une quelconque des revendications précédentes, selon laquelle ladite diode électroluminescente (LED) présente une tension de conduction (Vc) comprise entre 1,5 Volts et 3 Volts.

4. Montre thermoélectrique (1) selon l'une quelconque des revendications précédentes, selon laquelle ladite diode électroluminescente (LED) est alimentée par une tension batterie (Vbat) comprise entre 2 Volts et 4 Volts.

5. Montre thermoélectrique (1) selon l'une quelconque des revendications précédentes, selon laquelle ledit circuit de gestion d'énergie (30) est connecté à deux condensateurs (C1, C1') chacun couplé à une diode électroluminescente (LED1, LED2),
l'un des condensateurs (C1) étant configuré pour :
- subir une variation de charge (dQ) lorsque ladite sortie (HR_LOW) passe du premier état logique (S1) au deuxième état logique (S2),
- alimenter en courant la diode électroluminescente (LED1) à laquelle il est couplé lorsqu'il subit ladite variation de charge (dQ), ladite diode électroluminescente (LED1) étant configurée pour émettre une impulsion lumineuse dans le spectre du visible (L1) lorsqu'elle est parcourue par ledit courant,
l'autre des condensateurs (C1') étant configuré pour :
- subir une variation de charge (dQ) lorsque ladite sortie (HR_LOW) passe du deuxième état logique (S2) au premier état logique (S1),
- alimenter en courant la diode électroluminescente (LED2) à laquelle il est couplé lorsqu'il subit ladite variation de charge (dQ), ladite diode électroluminescente (LED2) étant configurée pour émettre une impulsion lumineuse dans le spectre du visible (L2) lorsqu'elle est parcourue par ledit courant.

6. Montre thermoélectrique (1) selon l'une quelconque des revendications précédentes, selon laquelle le circuit de gestion (30) comprend un étage amplificateur push-pull.

7. Montre thermoélectrique (1) selon l'une quelconque des revendications précédentes, selon laquelle ledit circuit de gestion d'énergie (30) est configuré pour gérer alternativement la charge de deux éléments de stockage d'énergie (40) de sorte à alimenter un moteur ou un affichage (50) de ladite montre thermoélectrique (1).

## Patentansprüche

1. Thermoelektrische Armbanduhr (1), umfassend:
- einen thermoelektrischen Generator (10),
- einen Spannungserhöher (20), der mit dem thermoelektrischen Generator (10) verbunden ist,
- eine Energiemanagementschaltung (30), die mit dem Spannungserhöher (20) verbunden ist und so konfiguriert ist, dass sie das Laden mindestens eines Energiespeicherelements (40) managt, wobei die Energiemanagementschaltung (30) einen Ausgang (HR_LOW) besitzt, der so konfiguriert ist, dass er von einem ersten logischen Zustand (S1) in einen zweiten logischen Zustand (S2) übergeht, wenn der thermoelektrische Generator (10) mit der elektrischen Energieerzeugung beginnt, und von dem zweiten logischen Zustand (S2) in den ersten logischen Zustand (S1) übergeht, wenn der thermoelektrische Generator (10) die elektrische Energieerzeugung beendet,
**dadurch gekennzeichnet, dass** sie ferner mindestens einen Kondensator (C1) umfasst, der mit der Energiemanagementschaltung (30) verbunden ist, mit einer Leuchtdiode (LED) gekoppelt ist und konfiguriert ist zum:
- Erfahren einer Ladungsänderung (dQ), wenn der Ausgang (HR_LOW) der Energiemanagementschaltung (30) entweder von seinem ersten Zustand (S1) in seinen zweiten Zustand (S2) oder von seinem zweiten Zustand (S2) in seinen ersten Zustand (S1) übergeht,
- Versorgen der Leuchtdiode (LED) mit Strom, wenn er die Ladungsänderung (dQ) erfährt, wobei die Leuchtdiode (LED) so konfiguriert ist, dass sie einen Lichtimpuls (L) im sichtbaren Spektrum emittiert, wenn sie vom Strom durchflossen ist.

2. Thermoelektrische Armbanduhr (1) nach dem vorhergehenden Anspruch, wobei ein Widerstand (R1) zur Leuchtdiode (LED) parallel geschaltet ist.

3. Thermoelektrische Armbanduhr (1) nach einem der vorhergehenden Ansprüche, wobei die Leuchtdiode (LED) eine Durchflussspannung (Vc) im Bereich von 1,5 Volt bis 3 Volt aufweist.

4. Thermoelektrische Armbanduhr (1) nach einem der vorhergehenden Ansprüche, wobei die Leuchtdiode (LED) mit einer Batteriespannung (Vbat) zwischen 2 Volt und 4 Volt versorgt wird.

5. Thermoelektrische Armbanduhr (1) nach einem der vorhergehenden Ansprüche, wobei die Energiemanagementschaltung (30) mit zwei Kondensatoren (C1, C1') verbunden ist, die jeweils mit einer Leuchtdiode (LED1, LED2) gekoppelt sind,
wobei einer (C1) der Kondensatoren konfiguriert ist zum:
- Erfahren einer Ladungsänderung (dQ), wenn der Ausgang (HR_LOW) vom ersten logischen Zustand (S1) in den zweiten logischen Zustand (S2) übergeht,
- Versorgen der Leuchtdiode (LED1), mit der er gekoppelt ist, mit Strom, wenn er die Ladungsänderung (dQ) erfährt, wobei die Leuchtdiode (LED1) so konfiguriert ist, dass sie einen Lichtimpuls (L1) im sichtbaren Spektrum emittiert, wenn sie vom Strom durchflossen wird,
wobei der andere (C1') der Kondensatoren konfiguriert ist zum:
- Erfahren einer Ladungsänderung (dQ), wenn der Ausgang (HR_LOW) vom zweiten logischen Zustand (S2) in den ersten logischen Zustand (S1) übergeht,
- Versorgen der Leuchtdiode (LED2), mit der er gekoppelt ist, mit Strom, wenn er die Ladungsänderung (dQ) erfährt, wobei die Leuchtdiode (LED2) so konfiguriert ist, dass sie einen Lichtimpuls (L2) im sichtbaren Spektrum emittiert, wenn sie vom Strom durchflossen wird.

6. Thermoelektrische Armbanduhr (1) nach einem der vorhergehenden Ansprüche, wobei die Managementschaltung (30) eine Push-Pull-Verstärkerstufe aufweist.

7. Thermoelektrische Armbanduhr (1) nach einem der vorhergehenden Ansprüche, wobei die Energiemanagementschaltung (30) so konfiguriert ist, dass sie abwechselnd die Ladung der beiden Energiespeicherelemente (40) managt, derart, dass ein Motor oder eine Anzeige (50) der thermoelektrischen Armbanduhr (1) versorgt wird.

## Claims

1. Thermoelectric watch (1) comprising:
- a thermoelectric generator (10),
- a voltage booster (20) connected to said thermoelectric generator (10);
- an energy management circuit (30) connected to said voltage booster (20) and configured to control the charging of at least one energy storage element (40), said energy management circuit (30) including an output (HR_LOW) configured to change from a first logic state (S1) to a second logic state (S2) when said thermoelectric generator (10) starts generating electrical energy, and to change from the second logic state (S2) to the first logic state (S1) when said thermoelectric generator (10) finishes generating electrical energy,
**characterized in that** the watch further includes at least one capacitor (C1) connected to said energy management circuit (30), coupled to a light emitting diode (LED), and configured to:
- undergo a variation of charge (dQ) when said output (HR_LOW) of said energy management circuit (30) changes either from the first state (S1) to the second state (S2), or from the second state (S2) to the first state (S1),
- supply current to said light emitting diode (LED) when said capacitor undergoes said variation of charge (dQ), said light emitting diode (LED) being configured to emit a light pulse in the visible spectrum (L) when said current flows therethrough.

2. Thermoelectric watch (1) according to the preceding claim, wherein a resistor (R1) is connected in parallel with the light emitting diode (LED).

3. Thermoelectric watch (1) according to any of the preceding claims, wherein said light emitting diode (LED) has a conduction voltage (Vc) comprised between 1.5 Volts and 3 Volts.

4. Thermoelectric watch (1) according to any of the preceding claims, wherein said light emitting diode (LED) is powered by a battery voltage (Vbat) comprised between 2 Volts and 4 Volts.

5. Thermoelectric watch (1) according to any of the preceding claims, wherein said energy management circuit (30) is connected to two capacitors (C1, C1'), each coupled to a light emitting diode (LED1, LED2), one of the capacitors (C1) being configured to:
- undergo a variation of charge (dQ) when said output (HR_LOW) changes from the first logic state (S1) to the second logic state (S2),
- supply current to the light emitting diode (LED1) to which it is coupled when said capacitor undergoes said variation of charge (dQ), said light emitting diode (LED1) being configured to emit a light pulse in the visible spectrum (L1) when said current flows therethrough,
the other capacitor (C1') being configured to:
- undergo a variation of charge (dQ) when said output (HR_LOW) changes from the second logic state (S2) to the first logic state (S1),
- supply current to the light emitting diode (LED2) to which said capacitor is coupled when it undergoes said variation of charge (dQ), said light emitting diode (LED2) being configured to emit a light pulse in the visible spectrum (L2) when said current flows therethrough.

6. Thermoelectric watch (1) according to any of the preceding claims, wherein the management circuit (30) includes a push-pull amplifier stage.

7. Thermoelectric watch (1) according to any of the preceding claims, wherein said energy management circuit (30) is configured to alternately control the charging of two energy storage elements (40) so as to power a motor or a display (50) of said thermoelectric watch (1).
